Europäisches Patentamt

European Patent Office

Office européen des brevets

(19)

(11) Veröffentlichungsnummer : **0 067 432**
**B1**

(12)
# EUROPÄISCHE PATENTSCHRIFT

(45) Veröffentlichungstag der Patentschrift :
01.10.86

(51) Int. Cl.⁴ : **G 08 B 19/00**, G 01 B 21/08,
**C 23 C 14/00**

(21) Anmeldenummer : 82105137.2

(22) Anmeldetag : 11.06.82

(54) Anordnung zum Messen des elektrischen Widerstandes und der Temperatur von durch Aufdampfen oder Aufstäuben auf Substraten abgeschiedenen dünnen metallisch-leitenden Schichten während der Schichtherstellung.

(30) Priorität : 12.06.81 DE 3123427

(43) Veröffentlichungstag der Anmeldung :
22.12.82 Patentblatt 82/51

(45) Bekanntmachung des Hinweises auf die Patenterteilung : 01.10.86 Patentblatt 86/40

(84) Benannte Vertragsstaaten :
AT BE CH FR GB IT LI LU NL SE

(56) Entgegenhaltungen :
DD-A-   79 240
DD-A-   108 559
DE-U- 1 984 959
US-A- 3 619 612
ELEKTRONIK, Band 24, Nr. 3, 1975, München B.
MACHULE "Mit Telemetric vom Messpunkt zum Messplatz" Seiten 72 bis 79

(73) Patentinhaber : Siemens Aktiengesellschaft Berlin
und München
Wittelsbacherplatz 2
D-8000 München 2 (DE)

(72) Erfinder : Hieber, Konrad, Dr. rer. nat.
Alblinger Strasse 3
D-8000 München 19 (DE)
Erfinder : Mayer, Norbert, Dr. rer. nat.
Höglwörther Strasse 216
D-8000 München 70 (DE)

**Beschreibung**

Die Patentanmeldung betrifft eine Anordnung zum Messen des elektrischen Widerstandes und der Temperatur von durch Aufdampfen oder Aufstäuben auf Substraten abgeschiedenen dünnen metallisch leitenden Schichten während der Schichtherstellung, wobei als Beschichtungsanlage ein evakuierter Rezipient mit einer evakuierbaren Schleusenkammer verwendet wird und der Substrathalter bewegbar ausgebildet ist, wobei ferner der elektrische Widerstand der Schicht nach dem Prinzip der Zwei- oder Vierpunkt-Meßmethode an einem Referenzsubstrat definierter Probengeometrie mit niederohmigen Kontakten und die Substrat-Temperatur mittels Widerstandsthermometer gemessen wird.

Bei der Herstellung dünner metallisch leitender Schichten, z. B. für Leiterbahnen in der Halbleitertechnologie oder für Widerstandsschichten in der Dünnschicht-Technik, werden hohe Anforderungen an die Toleranz und Konstanz der elektrischen Eigenschaften gestellt. So dürfen die Absolutwerte der elektrischen Flächenwiderstande z. B. von Dünnschichtwiderständen aus z. B. Cr-Ni, Al-Ta, Cr-Si von Charge zu Charge nur um wenige Prozent variieren, wobei der Temperaturkoeffizient des elektrischen Widerstandes oft nur wenige $10^{-6}$ $K^{-1}$ betragen darf. Ferner darf sich der Widerstandswert der oft nur 10 nm dicken Schichten innerhalb von vielen Jahren nur um wenige Prozent ändern.

Um diese hohe Reproduzierbarkeit zu erreichen, muß der Restgasdruck in den Aufdampf- bzw. Kathodenzerstäubungsanlagen besser $10^{-6}$ mbar sein. Um solch einen geringen Restgasdruck auch unter fertigungsmäßigen Bedingungen, das sind kurze Zykluszeit und großer Substratdurchsatz, aufrecht zu erhalten, werden Aufdampf- und Kathodenzerstäubungsanlagen mit Vakuumschleusen verwendet, d. h., daß die Substrate bei geöffneter Schleuse auf einen Substrathalter, z. B. einer Palette, montiert werden und anschließend bei geschlossener Schleuse — nach Erreichen eines bestimmten Enddruckes — mittels der Palette in die eigentliche Beschichtungskammer transportiert werden. Eine solche Beschichtungsanlage mit Schleusenkammer ist aus der DE-OS 29 09 804 bekannt. Während der Beschichtung müssen die Substrate noch bewegt werden, um die geforderte Homogenität der Schicht zu erreichen. Dies bedeutet, daß es keine definierte oder fixierte Lage eines Substrates in der Beschichtungskammer gibt.

Um das Ende des Beschichtungsprozesses genau bestimmen zu können, wäre eine Widerstandsmessung während der Beschichtung von großem technischen Vorteil. Damit könnte man das Erreichen der geforderten elektrischen Werte, z. B. des Flächenwiderstandes, messen. Außerdem wäre es sogar möglich, das Schichtwachstum praktisch von der ersten Monolage an, wie in der deutschen Patentanmeldung P 30 04 149.7 vorgeschlagen, zu verfolgen und entsprechend zu steuern.

Da die Substrattemperatur während der Beschichtung (20 °C bis 500 °C) sowohl die elektrischen Eigenschaften als auch die Stabilität der Schicht empfindlich beeinflussen kann, ist auch die Kenntnis dieser Größe für einen reproduzierbaren Beschichtungsprozeß von Bedeutung.

Die Aufgabe, die der Erfindung zugrundeliegt, besteht deshalb darin, eine Meßanordnung zu schaffen, mit der es möglich ist, den elektrischen Widerstand während des Beschichtungsprozesses zu bestimmen, wobei berücksichtigt wird, daß

a) eine Anlage mit Schleusenkammer verwendet werden muß,

b) die Substratpalette bewegt wird, um eine homogene Beschichtung zu erzielen und

c) gleichzeitig mit der Messung des elektrischen Widerstandes die Substrattemperatur (bis zu 500 °C) gemessen werden kann.

Diese Meßanordnung soll auch anwendbar sein, wenn während der Beschichtung Ionen und/oder Elektronen auf das Substrat auftreffen.

Die Widerstandsmessung in Aufdampf- bzw. Kathodenzerstäubungsanlagen während der Beschichtung wurde bisher auf verschiedene Art gelöst. Die erste Möglichkeit besteht darin, daß ein ortsfestes Referenzsubstrat verwendet wird, wobei in vielen Versuchen eine Zuordnung zwischen den elektrischen Werten des bewegten Substrates und des Referenzsubstrates ermittelt wird. Eine weitere Möglichkeit besteht darin, mittels Schleifkontakten den Widerstand am bewegten Substrat abzugreifen. Diese Methode ist jedoch nur dann erfolgreich, wenn die Substrate eine definierte Lage in der Beschichtungskammer einnehmen ; dies ist der Fall bei Anlagen ohne Schleuse, oder wenn die Substrate um eine Achse rotieren, wobei der Substrathalter mit der Drehachse fest verbunden ist. Unter ähnlichen Voraussetzungen ist auch nur eine Methode anwendbar, bei der ein bewegtes Substrat mittels flexibler Drähte kontaktiert ist. Hierbei muß jedoch die Drehrichtung während der Beschichtung mehrmals gewechselt werden, damit sich die aufgewickelten Drähte wieder abspulen können.

Zur kontaktlosen Messung der Substrattemperatur während der Schichtherstellung werden derzeit bereits Infrarotstrahlungsmeßgeräte eingesetzt. Dabei ergeben sich Probleme bezüglich der Meßgenauigkeit, da die Glasfiberoptik zum Teil mitbeschichtet wird.

Die Erfindung löst die obengestellte Aufgabe durch eine Meßanordnung der eingangs genannten Art dadurch, daß die Übertragung der Meßdaten berührungsfrei durch elektromagnetische Strahlung im Pulscodemodulations (PCM)-Verfahren erfolgt und daß ein telemetrisches Meßsystem als unabhängige Einheit an den beweglichen Substrathalter montiert ist, welches aus folgenden Übertragungseinheiten besteht :

a) einem Umsetzer, der die einzelnen Meßplätze (Referenzsubstrat, Temperatur) zyklisch abtastet und die analoge Meßspannung in digitale Signale verwandelt,

b) einem Sender, der mit dem Umsetzer und der Stromversorgung verbunden ist,

c) einer Empfangsantenne, die isoliert an der Innenseite des Rezipienten angebracht ist und

d) einem Empfänger, der mit der Empfangsantenne verbunden außerhalb des Rezipienten angeordnet ist und die Signalaufbereitung übernimmt.

Zur telemetrischen Übertragung der Meßdaten kommen ein Hochfrequenzsender mit Antenne als Empfänger, eine induktive oder kapazitive Kopplung zwischen Substratpalette und Rezipient oder ein Infrarotsender mit Infrarotempfänger als Empfangsantenne in Frage.

In einer Weiterbildung des Erfindungsgedankens ist vorgesehen, wenn die Meßdaten bereits digital vorliegen, daß sie direkt von einem Prozeßrechner übernommen werden, der die sofortige Auswertung übernimmt.

Das gesamte Meßsystem ist gemäß einem Ausführungsbeispiel nach der Erfindung in miniaturisierter Bauart ausgeführt, so daß es ohne wesentliche Störung der Geometrie an dem Substrathalter befestigt werden kann. Bei der miniaturisierten Bauart werden die passiven Elemente der Schaltung wie z. B. Leiterbahnen, Widerstände, Kapazitäten und Induktivitäten in Dickschicht- bzw. Dünnschicht-Technik auf Keramik oder Glassubstraten aufgebracht. Die Schichtdicke dieser Elemente liegt zwischen 10 nm und 5 000 nm. Die aktiven Elemente, wie z. B. Dioden oder Transistoren, werden in die Schichtschaltung nachträglich integriert. Ferner ist das Meßsystem derartig aufgebaut, daß eine Verunreinigung des Vakuums im Rezipienten durch Abdampfen von Atomen vom Meßsystem vermieden wird. Dies kann erreicht werden, entweder durch Verwendung spezieller Materialien und Bauelemente oder durch Einkapselung aller Bauteile. Durch geeignete wärmeisolierende Montage auf der Seite des Substrathalters, die einer eventuell vorhandenen Wärmequelle abgewandt ist, kann das Meßsystem auch bei höheren Beschichtungstemperaturen verwendet werden. Die Stromversorgung des Meßsystems kann entweder über eine Batterie, oder über einen einzelnen Schleifkontakt von außen, oder über eine Solarzelle, die über das Plasmaleuchten gespeist wird, erfolgen.

Im folgenden wird die Erfindung anhand eines Ausführungsbeispiels und der Figuren 1 bis 5 noch näher beschrieben. Dabei zeigt

die Figur 1 das für die Messung vorgesehene Referenzsubstrat in Draufsicht,

die Figur 2 das Referenzsubstrat mit Blende und Meßkontakten in Draufsicht,

die Figuren 3 und 4 Schnittbilder durch die Doppelpalette mit Referenzsubstrat und Meßsystem entsprechend Figur 2 und

die Figur 5 den funktionellen Zusammenhang des Meßsystems und seine Anordnung in bzw. zu der Beschichtungsanlage.

Als Ausführungsbeispiel wird der Meßaufbau für eine Kathodenzerstäubungsanlage mit einem ebenen Substrathalter beschrieben. Die Beschichtung und Erwärmung der Substrate erfolgt bei diesem Ausführungsbeispiel von oben.

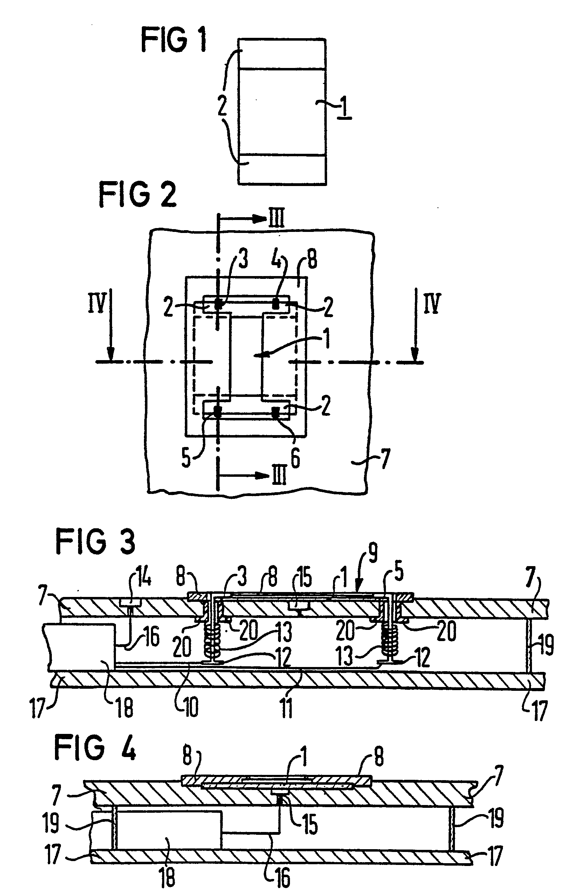

Die Messung des elektrischen Widerstandes der aufgestäubten Schicht erfolgt an einem Referenzsubstrat 1, das mit niederohmigen Kontakten 2 versehen ist (siehe Figur 1).

An diesem Referenzsubstrat (1, 2) werden, wie aus Figur 2 ersichtlich ist, zur Messung des elektrischen Widerstandes nach der Vier-Punkt-Methode vier Meßkontakte 3, 4, 5, 6 angebracht, welche von unten durch die Substratpalette 7 hindurch herangeführt werden und auf den dort bereits aufgebrachten niederohmigen Kontakten 2 aufliegen. Die Messung kann auch nach der Zwei-Punkt-Meßmethode mit Hilfe von Gleich- oder Wechselstrom durchgeführt werden. Im Falle einer Gleichstrom-Widerstandsmessung wird ein konstanter Strom an den zu messenden Widerstand angelegt (typisch zwischen 0,1 μA und 1 mA). Die über den Widerstand abfallende Spannung wird als Meßgröße dem Umsetzer (PCM-Modulator) zugeführt. Filter und ein Meßverstärker können dem PCM-Modulator noch vorgeschaltet sein, um ein besseres Meßsignal zu erreichen.

Über dem Referenzsubstrat 1 wird eine Blende 8 mit definierten Abmessungen angebracht, so daß das Referenzsubstrat 1 mit festgelegter Geometrie beschichtet wird. Die Blende 8 muß so gebaut sein, daß kein elektrischer Kurzschluß zwischen Blende und zu messender Schicht auftreten kann (siehe auch Figur 4). Über die Geometrie der Blende 8 kann je nach dem spezifischen elektrischen Widerstand des zu messenden Materials die absolute Größe des zu messenden Widerstandes eingestellt werden.

Wie aus Figur 3 ersichtlich ist, liegt das Referenzsubstrat 1 in einer Vertiefung (siehe Pfeil 9) der Palette 7. Die Meßleitungen 10, 11 zur Widerstandsmessung werden von unten durch die das Referenzsubstrat 1 tragende Palette 7 hindurch in der Art von Klammern 12 mit Federn 13 an das Referenzsubstrat 1 herangeführt und liegen auf den dort bereits aufgebrachten niederohmigen Kontakten 3 und 5 auf. Hierdurch wird das Referenzsubstrat 1 auf der Substratpalette 7 fixiert. Die Messung der Temperatur erfolgt mit Hilfe von Widerstandsthermometern 14 und 15, die von unten über Meßleitungen 16 an der Palettenoberfläche 7 angebracht sind. Das Meßsystem 18 zur Messung der elektrischen Widerstände, bestehend aus Umsetzer (PCM-Modulator), Sender und Stromversorgung, wird unterhalb der Substratpalette 7 angebracht. Hierzu wird unter der eigentlichen Substratpalette 7 eine zweite Palette 17 befestigt, die nur über wenige schlecht wärmeleitende Distanzstücke 19 mit der eigentlichen Substratpalette 7 verbunden ist. Das Meßsystem 18 einschließlich Sender ist in miniaturisierter Bauart ausgeführt ; es kann so eine relativ große laterale Ausdehnung bei nur geringer Einbauhöhe besitzen und hat so genügend Raum zwischen den beiden Paletten 7 und 17. Die gesamte Höhe des Doppelpalettensystems 7, 17 beträgt im Ausführungsbeispiel etwa 20 mm. Mit dem Bezugszeichen 20 sind Isolierungen bezeichnet.

In Figur 4, welche ein Schnittbild von Figur 2 in Richtung IV-IV darstellt, gelten die gleichen Bezugszeichen wie in Figur 1, 2 und 3.

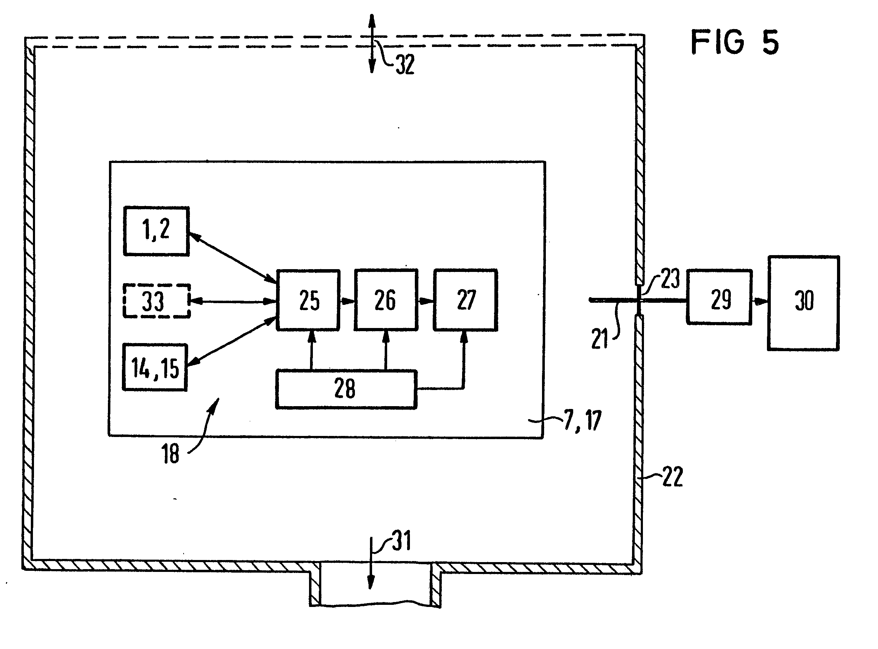

Wie aus der Figur 5 zu entnehmen ist, stellt das in die Doppelpalette 7, 17 eingebaute Meßsystem 18 mit dem Sender 27 ein unabhängiges System dar. Die Meßdatenübertragung von der rotierenden Palette 7, 17 erfolgt über ein Telemetriesystem, wobei sich der Umsetzer, der die Meßspannung, die an der Schicht 1, 2 gemessen worden ist, in übertragungsfähige Puls-Code-Modulations-Signale verwandelt unter der Palette befindet. Die Meßapparatur (18) einschließlich Sender 27 wird mit einer Batterie 28 betrieben. Die Empfangsantenne 21 wird bei Verwendung von HF-Technik bei der Meßdatenübertragung innerhalb des Rezipienten 22 angebracht und über eine isolierte Vakuumdurchführung 23 aus dem Rezipienten 22 herausgeführt. Die Einheit zur Aufbereitung der empfangenen telemetrischen Daten, der Empfänger 29, befindet sich außerhalb der Anlage (22). Die Meßdaten können dann als digitale oder analoge Signale zur Auswertung vorliegen. Wenn die Meßdaten digital vorliegen, können sie direkt von einem Computer 30 übernommen werden, der die sofortige Auswertung übernimmt und gegebenenfalls gemäß Patentanmeldung P 30 04 149.7 die Korrekturen für die einzelnen Beschichtungsparameter berechnet und die Beschichtungsparameter entsprechend ändert.

In dem In Figur 5 dargestellten Blockdiagramm über den Meßablauf gelten folgende Bezugszeichen :

Schicht = 1, 2
Widerstandsthermometer = 14, 15
Widerstandsmessung = 25
Umsetzer = 26 (PCM-Modulator)
Sender = 27
Stromversorgung = 28
Empfangsantenne = 21
isolierte Vakuumdurchführung für Antenne = 23
Empfänger = 29
Computer = 30

Der einfache Pfeil 31 in Figur 5 kennzeichnet den Vakuumanschluß des Rezipienten 22, der Doppelpfeil 32 die angebaute Schleusenkammer. Der mit der strichlierten Linie umrissene Bereich 33 soll die Möglichkeit für weitere Meßplätze andeuten.

Im PCM-Modulator (26) werden die einzelnen Meßstellen zyklisch abgetastet und die analoge Größe der Meßspannung in eine digitale Größe verwandelt.

## Patentansprüche

1. Anordnung zum Messen des elektrischen Widerstandes und der Temperatur von durch Aufdampfen oder Aufstäuben auf Substraten abgeschiedenen dünnen, metallisch leitenden Schichten während der Schichtherstellung, wobei als Beschichtungsanlage ein evakuierter Rezipient (22) mit einer evakuierbaren Schleusenkammer (32) verwendet wird und der Substrathalter (7, 17) bewegbar ausgebildet ist, wobei ferner der elektrische Widerstand der Schicht (1, 2) nach dem Prinzip der Zwei- oder Vierpunkt-Meßmethode an einem Referenzsubstrat (1) definierter Probengeometrie mit niederohmigen Kontakten (2) und/oder die Substrat-Temperatur mittels Widerstandsthermometer (14, 15) gemessen wird, dadurch gekennzeichnet, daß die Übertragung der Meßdaten berührungsfrei durch elektromagnetische Strahlung im Pulscodemodulations (PCM)-Verfahren erfolgt und daß ein telemetrisches Meßsystem (18) als unabhängige Einheit an den beweglichen Substrathalter (7, 17) montiert ist, welches aus folgenden Übertragungseinheiten besteht :

a) einem Umsetzer (25, 26), der die einzelnen Meßplätze (Referenzsubstrat, Temperatur) zyklisch abtastet und die analoge Meßspannung in digitale Signale verwandelt,

b) einem Sender (27), der mit dem Umsetzer (25, 26) und der Stromversorgung (28) verbunden ist,

c) einer Empfangsantenne (21), die isoliert (23) an der Innenseite des Rezipienten (22) angebracht ist und

d) einem Empfänger (29), der mit der Empfangsantenne (21) verbunden außerhalb des Rezipienten (22) angeordnet ist und die Signalaufbereitung übernimmt.

2. Anordnung nach Anspruch 1, dadurch gekennzeichnet, daß in Abänderung der Anordnung die Stromversorgung (28) des Meßsystems (18) nicht am Substrathalter (7, 17) angebracht ist, sondern über einen einzelnen Schleifkontakt von außen erfolgt.

3. Anordnung nach Anspruch 1 und/oder 2, dadurch gekennzeichnet, daß der Sender (27) ein HF-Sender ist und die Empfangsantenne (21) eine Antenne ist, die in einer isolierten Vakuumdurchführung (23) in den Rezipienten (22) eingeführt ist.

4. Anordnung nach einem der Ansprüche 1 bis 3, dadurch gekennzeichnet, daß der Sender ein Infrarotsender und die Empfangsantenne ein Infrarot empfindlicher Sensor ist.

5. Anordnung nach einem der Ansprüche 1 bis 4, dadurch gekennzeichnet, daß der Empfänger (29) zur Übernahme der digitalen Meßdaten mit einem Prozeßrechner (30) gekoppelt ist (Figur 5).

6. Anordnung nach einem der Ansprüche 1 bis 5, dadurch gekennzeichnet, daß das telemetrische Meßsystem (18) in Miniaturbauweise ausgeführt ist und wärmeisoliert am Substrathalter (7, 17) montiert ist (Figur 5).

7. Anordnung nach einem der Ansprüche 1 bis 6, dadurch gekennzeichnet, daß das Material für die Montageteile sowie die elektrischen Bauelemente so ausgewählt ist, daß eine Vakuumverunreinigung ausgeschlossen ist.

8. Anordnung nach einem der Ansprüche 1 bis 7, dadurch gekennzeichnet, daß das an der Palette (7, 17) montierte Meßsystem (18) vakuumdicht eingekapselt ist (Figur 3 und 4).

9. Anordnung nach einem der Ansprüche 1 bis 8, dadurch gekennzeichnet, daß zur Aufnahme des Meßsystems (18) der Substrathalter (7, 17) als Doppelpalette ausgebildet ist, wobei die das Referenzsubstrat (1) enthaltende eigentliche Substratplatte (7) über Distanzstücke (19) mit einer zweiten Palette (17) verbunden ist und so den Zwischenraum für das Meßsystem (18) schafft (Figur 3 und 4).

10. Anordnung nach einem der Ansprüche 1 bis 9, dadurch gekennzeichnet, daß das Referenzsubstrat (1) auf dem Substrathalter (7) durch die von unten durch den Substrathalter (7) geführten Meßkontakte (10, 11) mittels Federkraft (12, 13) fixiert ist (Figur 3).

11. Anordnung nach einem der Ansprüche 1 bis 10, dadurch gekennzeichnet, daß die zur Messung der Substrattemperatur vorgesehenen Widerstandsthermometer (14, 15) unmittelbar unterhalb des Referenzsubstrates (1) angeordnet sind (Figur 3 und 4).

12. Anordnung nach einem der Ansprüche 1 bis 11, dadurch gekennzeichnet, daß mehrere Referenzsubstrat und mehrere Temperaturplätze (33) vom Umsetzer (26) erfaßbar sind (Figur 5).

13. Anordnung nach einem der Ansprüche 1 bis 12, dadurch gekennzeichnet, daß elektrische Filter zur Entsörung der beim Aufstäuben auftretenden Hochfrequenz vorgesehen sind.

14. Anordnung nach einem der Ansprüche 1 bis 13, dadurch gekennzeichnet, daß ein Verstärker, dem Umsetzer vorgeschaltet, die analoge Meßspannung verstärkt.

15. Anordnung nach einem der Ansprüche 1 bis 14, dadurch gekennzeichnet, daß die Stromversorgung (28) des Meßsystems (18) über Batterien oder über Solarzellen, die durch das Plasmaleuchten gespeist werden, erfolgt (Figur 5).

## Claims

1. Arrangement for measuring the electric resistance and the temperature of thin metallic conducting layers which are deposited on substrates by vapour-deposition or sputtering, wherein an evacuated recipient (22) having a lock chamber (32) which can be evacuated is used as a coating system and the substrate holder (7, 17) is movable, wherein furthermore the electrical resistance of the layer (1, 2) is measured in accordance with the principle of two or four point measuring method on a reference substrate (1) of defined sample geometry with low-ohmic contacts (2) and/or the substrate temperature is measured by means of resistance thermometers (14, 15) characterised in that the transmission of the measured data is carried out in non-contacting manner by electro-magnetic radiation in the pulse code modulation (PCM) method, and that a telemetric measuring system (18) is mounted onto the movable substrate holder (7, 17) as an independent unit, which consists of the following transmission units :

    a) a converter (25, 26) which cyclically scans the individual measuring locations (reference substrate, temperature) and converts the analogue measuring voltage into digital signals,

    b) a transmitter (27) connected to the converter (25, 26) and to the current supply unit (28),

    c) a receiving antenna (21) fixed on the inside of the recipient (22) so as to be insulated (23) and

    d) a receiver (29) connected to the receiving antenna (21) and arranged outside the recipient (22) and which takes over the signal processing.

2. An arrangement as claimed in Claim 1, characterised in that in the modified arrangement the current supply unit (28) of the measuring system (18) is not fixed to the substrate holder (7, 17), but is effected from the outside by means of an individual sliding contact.

3. An arrangement as claimed in Claim 1 and/or Claim 2, characterised in that the transmitter (27) is an HF transmitter and the receiving antenna (21) is an antenna inserted into the recipient (22) in an insulated vacuum duct (23).

4. An arrangement as claimed in one of Claims 1 to 3, characterised in that the transmitter is an infra-red transmitter and the receiving antenna is a sensor sensitive to infra-red.

5. An arrangement as claimed in one of Claims 1 to 4, characterised in that the receiver (29) is coupled to a process computer (30) in order to receive the digital measured data (Figure 5).

6. An arrangement as claimed in one of Claims 1 to 5, characterised in that the telemetric measuring system (18) is miniaturized and mounted on the substrate holder (7, 17) so as to be insulated (Figure 5).

7. An arrangement as claimed in one of Claims 1 to 6, characterised in that the material for the assembly components and the electrical components are selected such that vacuum pollution is excluded.

8. An arrangement as claimed in one of Claims 1 to 7, characterised in that the measuring device (18) mounted on the plate (7, 17) is encapsulated so as to be vacuum-tight (Figure 3 and 4).

9. An arrangement as claimed in one of Claims 1 to 8, characterised in that in order to accommodate the measuring system (18) the substrate holder (7, 17) is designed as a double plate, where the actual substrate plate (7) which comprises the reference substrate (1) is connected to a second plate (17) by means of spacers (19) and thus creates the interspace for the measuring system (Figure 3 and 4).

10. An arrangement as claimed in one of Claims 1 to 9, characterised in that the reference substrate (1) is fixed on the substrate holder (7) by means of spring tension (12, 13) via the measuring contacts (10, 11) which are led through the substrate holder (7) from the base.

11. An arrangement as claimed in one of Claims 1 to 10, characterised in that the resistance thermometers (14, 15) which are provided for the measurement of the substrate temperature are arranged directly below the reference substrate (1) (Figure 3 and 4).

12. An arrangement as claimed in one of Claims 1 to 11, characterised in that a plurality of reference substrates and a plurality of temperature locations (33) can be detected by the converter (26) (Figure 5).

13. An arrangement as claimed in one of Claims 1 to 12, characterised in that electrical filters are provided for the interference elimination of the high frequency which occurs during the sputtering operation.

14. An arrangement as claimed in one of Claims 1 to 13, characterised in that an amplifier is connected preceding the converter and amplifies the analogue measuring voltage.

15. An arrangement as claimed in one of Claims 1 to 14, characterised in that the current supply (28) of the measuring system (18) is effected by means of batteries or solar cells fed by the plasma luminescence.

## Revendications

1. Dispositif pour mesurer la résistance électrique et la température de couches minces conductrices métalliques déposées par évaporation ou par pulvérisation sur des substrats, pendant la fabrication des couches, et dans lequel on utilise, comme installation de dépôt, un récipient (22), dans lequel le vide est établi et qui comporte une chambre formant sas (32), dans lequel le vide peut être établi, et le porte-substrats (7, 17) est réalisé de manière à être déplaçable, et dans lequel en outre la résistance électrique de la couche (1, 2) est mesurée selon le principe du procédé de mesure en deux ou en quatre points sur un substrat de référence (1) possédant une géométrie d'essai définie avec des contacts (2) de faible valeur ohmique, et/ou la température du substrat est mesurée à l'aide de thermomètres à résistance (14, 15), caractérisé par le fait que la transmission des données de mesure s'effectue sans contact, par rayonnement électromagnétique selon le procédé de modulation par impulsions codées (MIC), et qu'un système de mesure télémétrique (18) est monté, sous la forme d'une unité indépendante, et que sur le porte-substrats (7, 17) mobile se trouve installé, sous la forme d'une unité indépendante, un système de mesure télémétrique (18) qui est constitué par les unités de transmission suivantes :

a) un convertisseur (25, 26) qui explore cycliquement les différents emplacements de mesure (substrat de référence, température) et convertit la tension de mesure analogique en des signaux numériques,

b) un émetteur (27) qui est relié au convertisseur (25, 26) et à l'alimentation en courant (28),

c) une antenne réceptrice (21) qui est montée en étant isolée (23) sur la face intérieure du récipient (22), et

d) un récepteur (29) qui est disposé à l'extérieur du récipient (22), en étant relié à l'antenne réceptrice (21), et se charge de la préparation des signaux.

2. Dispositif suivant la revendication 1, caractérisé par le fait, qu'à titre de variante du dispositif, l'alimentation en courant (28) du système de mesure (18) n'est pas installée sur le porte-substrats (7, 17), mais s'effectue depuis l'extérieur par l'intermédiaire d'un contact glissant individuel.

3. Dispositif suivant la revendication 1 et/ou 2, caractérisé par le fait que l'émetteur (27) est un émetteur à haute fréquence et que l'antenne réceptrice (21) est une antenne qui est insérée dans une traversée sous vide (23) isolée, dans le récipient (22).

4. Dispositif suivant l'une des revendications 1 à 3, caractérisé par le fait que l'émetteur est un émetteur à infrarouge et que l'antenne réceptrice est un capteur sensible au rayonnement infrarouge.

5. Dispositif suivant l'une des revendications 1 à 4, caractérisé par le fait que, pour le transfert des données de mesure numériques, le récepteur (29) est accouplé à un calculateur de processus (30) (figure 5).

6. Dispositif suivant l'une des revendications 1 à 5, caractérisé par le fait que le système de mesure télémétrique (18) est réalisé sous la forme d'un système miniaturisé et est monté en étant thermiquement isolé, sur le porte-substrats (7, 17) (figure 5).

7. Dispositif suivant l'une des revendications 1 à 6, caractérisé par le fait que le matériau prévu pour les pièces de montage et pour les composants électriques est choisi de manière qu'une pollution sous vide soit exclue.

8. Dispositif suivant l'une des revendications 1 à 7, caractérisé par le fait que le système de mesure (18) monté sur la palette (7, 17) est encapsulé de façon étanche au vide (figures 3 et 4).

9. Dispositif suivant l'une des revendications 1 à 8, caractérisé par le fait que pour le montage du système de mesure (18), le porte-substrats (7, 17) est réalisé sous la forme d'une palette double, la palette (7) proprement dite du substrat, qui contient le substrat de référence (1), étant reliée par l'intermédiaire d'entretoises (19) à une seconde palette (17) et créant de ce fait l'espace intercalaire pour le système de mesure (18) (figures 3 et 4).

10. Dispositif suivant l'une des revendications 1 à 9, caractérisé par le fait que le substrat de référence (1) est fixé sur le porte-substrats (7) à l'aide d'une force élastique (12, 13), par les contacts de mesure (10, 11) traversant à partir du bas le porte-substrats (7) (figure 3).

11. Dispositif suivant l'une des revendications 1 à 10, caractérisé par le fait que les thermomètres à résistance (14, 15), qui sont prévus pour la mesure de la température du substrat, sont disposés directement au-dessous du substrat de référence (1) (figures 3 et 4).

12. Dispositif suivant l'une des revendications 1 à 11, caractérisé par le fait que plusieurs substrats de référence et plusieurs postes de mesure de température (33) peuvent être détectés par le convertisseur (26) (figure 5).

13. Dispositif suivant l'une des revendications 1 à 12, caractérisé par le fait que des filtres électriques sont prévus pour réaliser l'antiparasitage de la haute fréquence apparaissant lors de la pulvérisation.

14. Dispositif suivant l'une des revendications 1 à 13, caractérisé par le fait qu'un amplificateur, qui est monté en amont du convertisseur, amplifie la tension de mesure analogique.

15. Dispositif suivant l'une des revendications 1 à 14, caractérisé par le fait que l'alimentation en courant (28) du système de mesure (18) est réalisée par l'intermédiaire de piles ou de piles solaires, qui sont alimentées par la lumière du plasma (figure 5).

FIG 1

FIG 2

FIG 3

FIG 4

FIG 5